Europäisches Patentamt

European Patent Office

Office européen des brevets

(19)

(11) Publication number: 0 313 111
A2

# EUROPEAN PATENT APPLICATION

(21) Application number: 88200313.0

(51) Int. Cl.4: G03F 7/20

(22) Date of filing: 22.02.88

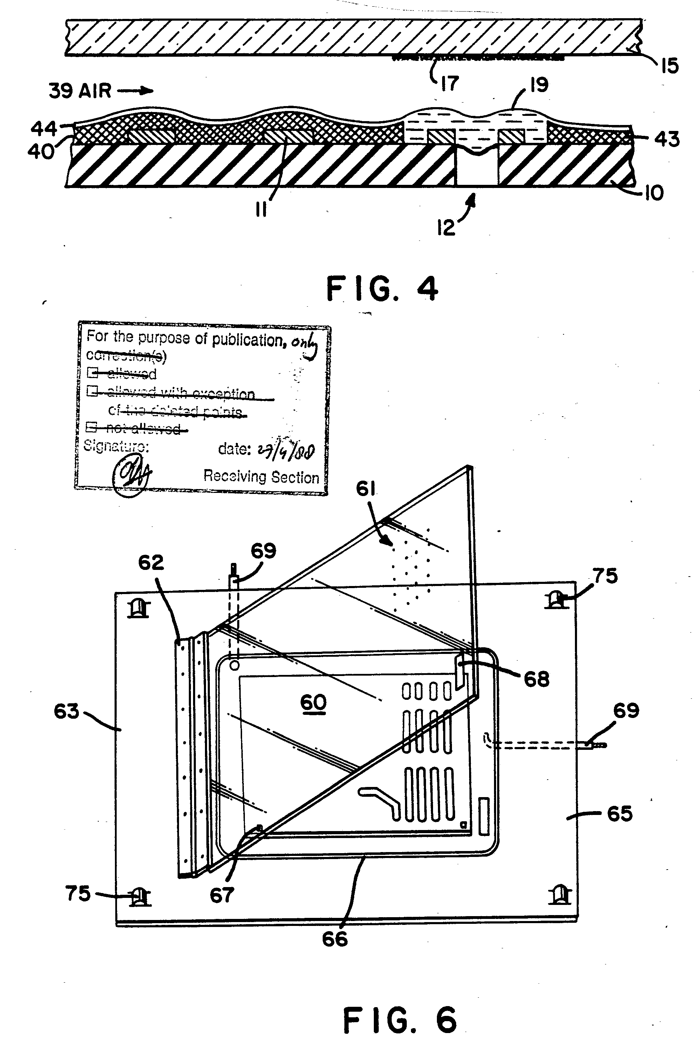

A request for addition of figures 4 + 6 to the application has been filed pursuant to Rule 88 EPC. A decision on the request will be taken during the proceedings before the Examining Division (Guidelines for Examination in the EPO, A-V, 2.2).

(30) Priority: 20.10.87 US 110505
21.10.87 US 110857

(43) Date of publication of application:
26.04.89 Bulletin 89/17

(84) Designated Contracting States:
DE FR GB IT NL

(71) Applicant: **Sullivan, Donald Fort**
**26 White Oak Road**
**Paradise Pennsylvania 17562(US)**

(72) Inventor: **Sullivan, Donald Fort**
**26 White Oak Road**
**Paradise Pennsylvania 17562(US)**

(74) Representative: **Petri, Stellan**
**c/o SAB NIFE AB Box 515**
**S-261 24 Landskrona(SE)**

(54) **Photoprinting with radiation transparent phototools.**

(57) A photopolymer layer is used as a radiation transparent in-situ phototool in the photographic process of producing solder mask layers on printed wiring boards. Various simplification and energy reducing steps are introduced with off-contact photoprinting of patterns on liquid photopolymers having special characteristics that permit the polymerization of patterned outer skin areas partly through the thickness thereof with a controlled amount of radiation energy. The skin pattern then becomes an in-situ surrogate phototool that permits further polymerization throughout the thickness of the layer with controlled quantities of unpatterned radiation energy. Photodiscrimination is provided in the further radiation step with the surrogate phototool by changes of photosensitivity in the layer transparent to radiation rather than by opaque imaging. Thus a first low energy photoflash through an off-contact phototool with uncollimated radiation creates on a liquid photopolymer surface two contrasting patterned areas of liquid polymer, one having a polymerized skin. This can be achieved in a gaseous atmosphere that does not react with the polymer surface. The second radiation curing step occurs in the presence of a gas such as air on the polymer surface, which inhibits polymerization in the presence of radiation energy. Thus with controlled radiation energy intensity the polymer layer is fully cured through the thickness of the layer in those patterned regions having cured skin covered portions without curing the patterned regions having a liquid surface.

FIG. 5

# PHOTOPRINTING WITH RADIATION TRANSPARENT PHOTOTOOLS

## Technical Field

This invention relates to photoprinting of patterns on photosensitive materials such as photopolymers, and more particularly it relates to the manufacture of printed wiring boards and the formation of thick solder mask layers of the order of 0.010 cm or greater in thickness over wiring traces.

## Background Art

This is an improvement over my US-A-4,618,567 for High Resolution Liquid Photopolymer Coating Patterns Over Irregular Printed Wiring Board Surface Conductors.

The prior art provides differing processes and apparatus for photopatterning photoactive materials, such as photopolymers in the liquid state, through partially opaque phototool patterns, usually transparencies, both off-contact and on-contact with the photo material surface. US-A-4,436,806, collimates radiated UV light in an off-contact process of patterning a coating of liquid photopolymer onto a printed wiring board. This is a one step printing process.

Many examples of on-contact processes for photopatterning liquid photopolymers are available in the art, but they generally are not pertinent to this invention which provides for off-contact photopatterning. Also photopatterning with a single radiation step through a phototool are known and are not pertinent to the two radiation step process afforded by this invention.

It is known in the art that oxygen and air on the surface of an oxygen sensitive photopolymer in its unstable state inhibits the polymerization into its stable state, thus requiring more radiation energy for conversion into the stable state than required when the surface is shielded from oxygen, such as by disposal of a non-reaction thin plastic film over the surface. W. Deforest in Photoresist Materials and Process, McGraw-Hill 1975, page 121, discusses the oxygen effects on photopolymerization and the use of an inert or nonreacting gas environment to reduce or eliminate the inhibiting effect of the oxygen on polymerization.

Multiple step UV curing of plastic materials is taught by US-A-4,411,931, wherein vinyl tile substrates are coated with urethaneacrylate coating compositions. Combinations of shorter and longer wavelength radiation steps of stronger and weaker intensity are used to control surface texture in the coating.

Curing of liquid photopolymer layers partially through their thickness is also known in the art, wherein the surface is left soft in a contact printing procedure that cures from the substrate surface outwardly through the thickness of the layer. US-A-4,528,261 thus discloses such a technique where the soft surface is then moved into contact with a printed wiring board and is then cured in a second photo radiation step using the same phototool. US-A-4,291,116 puts down two layers of liquid polymer on opposite sides of a screen fabric or stencil and cures them in two separate steps through the same phototool pattern in contact with the first layer, leaving an outer layer surface in contact with air in the liquid state as excess wasted polymer. Also my US-A-4,618,567 provides for two radiation exposure steps to photopattern two different strata in a liquid photopolymer layer, with the phototool off contact in one of two radiation steps.

In these prior art photopatterning processes there are several significant unresolved problems presented. Some are now discussed.

A phototool deteriorization problem is introduced whenever contact printing is involved, because of wear due to the abrasiveness of the polymer layer on a phototool image surface in contact. If the image surface is not in contact and is disposed on the remote side of a phototool carrier sheet, then the resolution is sacrificed because of interface reflection problems. Furthermore, the liquid photopolymer in cured areas tends to bond to the phototool and in the uncured areas the polymer tends to accumulate undesirably on the phototool surface.

Wet surface coatings remain when most UV curable liquid photopolymer layers are photopatterned with air, oxygen or other cure inhibiting gases on the surface. Thus, a considerable increase in light energy is required to effect polymerization. Furthermore, the outer surface coating is not easily cured to a dry state but is generally left wet, resulting in a waste of the photopolymer material. If enough energy is used in the photopatterning step to dry the outer layer, the polymer is overexposed elsewhere, resulting in low resolution distorting the photopatterned image from that of the phototool.

Typically the wet exterior surface still remaining in an unstable state that cannot resist developing chemicals may comprise 20% of the layer thickness. This results in considerable waste, since it is washed off in the development phase when the unpolymerized portions of the pattern are dissolved in solvent and washed out. Thus, for example in thick film solder mask layers disposed over circuit wiring traces, the insulation properties are significantly reduced. Use of compensating thicker layers would result in poorer resolution, since it is difficult to get high resolution with liquid photopolymers and with thick layers. Furthermore the developer solution, air dust, etc. may chemically or physically react on the liquid surface to permanently lock-in contaminates reducing the desired insulation property, or otherwise adversely affecting the performance characteristics.

A bonding problem to a substrate surface results when photopolymerizing thick layers of photopolymer of the order of 0.010 cm or greater, necessitated to overlay circuit traces that may extend up to 0.010 cm in relief from the substrate surface. The polymer layers thus must be hardened through the thickness down to the substrate and there be firmly bonded to the substrate surface. Again overexposure resulting from this need be avoided to eliminate deteriorization of the resolution.

In my US-A-4,618,567 resolution was increased by means of two photopatterning steps wherein the first is off-contact and the second is essentially on-contact by means of a plastic film layer contacting the wet outer surface remaining from the first photo step. This has the disadvantages of contact printing including the offset of some of the wet surface polymer onto the film layer and bonding of the cured pattern from the second photo step to the plastic film.

Non-collimated radiation causes image distortion in off-contact photo printing steps. Shadows are produced on the substrate so that it is difficult to get exact correspondence between the printed photopolymer image and that on the phototool.

Dissimilar thicknesses of the polymer layer, particularly in the case of solder mask coatings over circuit wiring traces, may give as much as five to one differences in thickness of the polymer layer to be cured. This happens with 0.013 cm thick layers over the substrate surface adherent to circuit traces thereon extending 0.010 cm above the substrate surface. The 0.003 cm thick portions over the traces then tend to be overexposed with poor resolution if enough energy is used to assure that the 0.013 cm thickness over the substrate surface adjacent to the traces is polymerized through its thickness and is bonded to the substrate.

The salvage of faulty wiring boards is a desired feature, not generally possible in the prior art. Complex circuit boards may be quite expensive, and thus rejects because of improper solder masking require destruction of the boards if the solder mask covers them with a bond so strong that the solder mask cannot be stripped without damage to the board, as is generally the case in the prior art.

High production costs resulting from high and inefficient energy requirements and low production speeds have been a problem throughout the prior art processes for photoprinting thick liquid polymer layers such as used in solder masks over printed wiring board circuit traces. This is particularly true for off contact printing methods, particularly in the presence of air on the polymer surface. Also production time is increased where a phototool need be dedicated to each workpiece from start to finish of the radiation cycle. Nowhere in the prior art has this bottleneck been resolved.

Wearing heating and distortion of phototools is a problem, particularly if of the thin film type, because of high radiation energy required for photopolymer curing. Production cycle time may be limited by the heat developed on the phototool, which may be considerable with high energy radiation absorbed by opaque phototool images. If the dimensions of the phototool image are changed by the heat, registration suffers.

## Objects of the Invention

It is therefore a general object of this invention to provide improved liquid photopolymer photopatterning processes and products resolving these aforementioned problems in the prior art.

A more specific object of the invention is to provide a high resolution photopatterning process for thick liquid photopolymer layers, of the order of 0.010 cm or more in thickness, that may use a wide range of photopolymers in a simple, fast production cycle particularly suited for printed wiring boards.

Another object of this invention is to produce fast production cycle times by reducing the heat developed on the phototool and the time necessary for its use in the curing cycle.

Other objects, features and advantages of the invention will be found throughout the following description, the drawings and the claims.

## Disclosure of the Invention

This invention significantly reduces the radiation energy on the phototool used in off-contact photopatterning of photopolymers. It can also reduce the dedicated time of a phototool in the radiation cure cycle to a small percentage of the cycle time, and significantly reduce the radiation energy during that reduced time period. Therefore the production rate can be increased significantly, and energy savings result. Furthermore, a simplified production process is afforded that means little equipment and has fewer and simpler steps than heretofore feasible. Nevertheless, unexpectedly, better resolution occurs and better control of the curing conditions so that the extent of bonding to the surface can be metered to permit reject board salvage, even in solder mask production with large variations of thickness and with thick films.

These advantages are achieved by a novel advance in the art changing the manner of imaging patterns in a photosensitive material. Thus, there is provided by this invention a novel surrogate phototool that is transparent to radiation thereby avoiding the heat losses and disadvantages afforded by opaque images, yet which advantageously serves with simpler capital equipment and faster production rates to pattern a body of photopolymer in a controllable configuration in response to actinic radiation therethrough. This novel phototool, transparent to radiation, is created in-situ in the polymer body itself by means of a short low energy radiation cycle through a conventional radiation blocking image pattern phototool with the outer surface shielded from inhibiting gas, so that an outer stratum skin layer is transformed into the stable state.

The invention thus comprises a photographic process operable on a photosensitive material, for example, a liquid photopolymer, which is convertable by actinic radiation from a first unstable state that is subject to chemical and physical distortion into a second stable state more resistant to chemical and physical distortion. One example of a production process of this nature is the formation of a solder mask coating on a printed wiring board from a layer of liquid photopolymer superimposed over a wiring pattern on the board substrate surface.

Thus, a body of the photosensitive material in an unstable state, for example, a layer of liquid photopolymer, is radiated with a controlled pattern and quantity of actinic radiation, such as by flashing a short burst of actinic energy through a phototransparency image to produce a pattern of material in the stable or polymerized state in the layer in a first radiating step. Thus, two different regions are formed in the layer respectively with unstable state and stable state material surface patterns to thereby define by the stable state surface pattern region a solder mask coating pattern or the like.

These two regions, comprising different portions of the polymer layer, are both transparent to actinic radiation. This would seem entirely inconsistent with their use as phototool. However, in accordance with this invention, they are made to define a pattern of two regions of different sensitivity to further actinic radiation. An outer skin stratum of the layer converted to the stable state by the short radiation flash with the underlying portion in the unstable state, thereby constitutes an in-situ phototool that is used to complete the cure or polymerization process throughout the layer thickness, thus converting only the desired patterned portion of the polymer layer into the stable state in the presence of further radiation, which is unpatterned, thereby freeing the original phototool for another workpiece.

In the liquid photopolymer embodiment of the invention, a special photopolymer is provided with the layer photosensitivity very low when its surface is in the presence of air, oxygen or other inhibiting gas, and thus requiring high intensity energy to change to the stable polymerized state. Conversely, when the surface is covered by a protective layer such as a thin plastic film, the photosensitivity becomes relatively very large, and less energy is required to change the state from the unstable liquid state into a polymerized stable state. This surface sensitivity characteristic, formerly undersirable, is used in the present invention to distinguish two different regions of different sensitivity to radiation in the presence of air on the surface as a phototool pattern for further polymerization.

To make the photopolymer body itself work as a phototool pattern, a thin stratum skin portion is converted to the stable state by a short flash of radiation through a conventional radiation blocking phototool image. In order to polymerize the outer skin, the conventional procedure of polymerizing from the substrate outwardly, and thereby leaving a liquid outer surface, need be abandoned. It was discovered in this invention that in the presence of an inert or non-reacting gas blanket at the photopolymer surface a short flash of radiation of controlled energy content would polymerize a skin deep portion of the polymer leaving the rest of the layer thereunder in its unstable state.

Then by converting the atmosphere at the surface to inhibiting air, there is a large contrast of sensitivity to radiation between the skin cured stable state regions and the uncured polymer regions at the surface. A controlled low intensity amount of unpatterned radiation energy is thus used to fully polymerize the desired portions of the body underlying the skin cured portions, thus in effect making a surrogate phototool out of the body itself. This new phototool has all the advantages then of contact printing without any disadvantages of interface reflections of energy, air bubbles between layers, etc. The resolution in the second radiation step will be greatly increased, since the phototool even extends below the surface of the photosensitive body and permits use of uncollimated radiation without serious loss of resolution from the shadow effect. Also the amount of radiation can be reduced and can be carefully metered to achieve the proper cure without overexposure or overbonding.

By converting the atmosphere to inhibiting air in the second radiation step, there is a large contrast of sensitivity to radiation between the skin cured regions and the uncured polymer regions on the polymer surface. A controlled low intensity amount of unpatterned radiation energy thus can be used to fully polymerize the desired unstable state portions of the body thickness underlying the skin cured portions. Thus, the amount of radiation can be reduced and can be carefully metered to achieve the proper cure without overexposure or overbonding.

Thus this invention uses two successive radiation steps in the presence of different gaseous atmospheres on the photopolymer layer to significantly reduce processing time and radiation energy requirements, while improving resolution so that thick layers may be patterned, such as for solder marking. A critical photosensitive material is used by this invention, which in one embodiment is a liquid polymer having the property that its photoresponse through a thick layer of the order of 0.010 cm on a substrate such as a printed wiring board has an enhanced inhibition characteristic. Thus, it resists cure throughout its thickness in the presence of an inhibiting gas including oxygen or air at the outer polymer surface.

In one embodiment this photopolymer layer is photo flashed through an imaged pattern on a phototool transparency in a short exposure step, typically ten seconds, in the presence of a nonreactive gas such as nitrogen or carbon dioxide in the first radiating step. This results in the polymerization of a surface stratum skin layer pattern having liquid polymer therebeneath where light-struck and having liquid polymer throughout the layer where light is blocked.

In the second radiating step the layer is further exposed in the presence of air at the surface, which serves to inhibit the polymerization of the layer where the liquid polymer is present on the surface but not where the liquid polymer is protected by the skin pattern. The radiation intensity is metered to be of a magnitude that will cure the polymer layer under the skin covered regions but not to overcome the threshold level to cause polymerization to occur in the liquid surfaced regions. Typically, this second exposure period can range from one to three minutes, and this converts the liquid polymer from the unstable liquid state into a stable cured or polymerized state that chemically resists the solvents which are used to wash out the liquid state portions of the pattern in a following development step. The second radiating step also bonds the polymer layer to the substrate and the bond can be controlled to be sufficient for further processing with the substrate including development in a solvent where the stable state polymer is chemically resistant to the solvent, but not so secure as to prevent stripping from reject workpieces. A further more intense curing step can follow inspection or washout steps to permanently bond the polymer to the substrate.

The second radiating step can be done in the presence of the same phototool in registration, but surprisingly no further phototool need be used. Thus, the first step creates in the photosensitive material body itself a surrogate in-situ phototool image which acts to control the further photoconversion of the photosensitive material. Even though this phototool, comprising a photopolymer layer, for example, is transparent to radiation, nevertheless it is used as a phototool pattern to further cure the photosensitive material body.

Thus, in accordance with this invention, a novel type photomask is created operating in a different mode from the conventional light blocking transparency with opaque images. The photopolymer layer is thus patterned by the first exposure step into two regions having the respective properties of reacting with different photo sensitivity to further radiation. Then the second radiating or exposure step (in the presence of air) selects a radiation intensity level that distinguishes between the two regions of different photo sensitivity. In the liquid photopolymer embodiment, thus a polymer is provided with a large contrast between the photosensitivity with and without the surface in the stable state. It is radiated in the presence of air on the surface to inhibit the curing in the regions having a liquid polymer surface with enough intensity to cure those regions protected from the air by the skin portion that is in the stable cured state, but not enough to cure any of the layer beneath the unstable liquid surface regions. Accordingly the different sensitivities to radiation created by stable state surface stratum air shielding structure formed in the photosensitive layer by the first photo flash step are employed as a phototool in accordance with this invention. In this manner unpatterned radiation passed through a radiation transparent photosensitive material body photoconverts that material into a designated pattern of unstable and stable state material.

By this means therefore, the photosensitive material is in effect its own phototool and the external light blocking photomask is not necessary in the follow-through curing of the second step. This leads to a fast efficient process wherein the phototool need only be dedicated to the process for a short portion of the exposure time, and the resulting product from the first radiating step can be cured in mass by unpatterned radiation in a light tunnel or the like.

In terms of the photosensitivity of the liquid photopolymer pattern with the liquid state surface, it is essentially zero for the amount of light intensity used in the second radiation step. By contrast the photosensitivity of the liquid photopolymer in the liquid state under the cured skin pattern is very high so that it may be polymerized with low energy levels over a duration that does not overexpose the polymer and thus reduce the resolution.

This invention thus provides a process of increasing the photosensitivity of a liquid photopolymer layer in a predetermined pattern by photo-flashing through a phototool image to establish the pattern with only enough energy to partially polymerize the layer through its thickness, with the outside surface of the layer polymerized. This is achieved by the presence of a gas blanket, or equivalent, that overcomes the oxygen, etc. inhibition characteristic of such liquid photopolymers. Thus, a superior phototool, operating on a new principle, is afforded by this invention. There will be many applications, not now evident, of such discrimination in the sensitivity of photo sensitive layers, that can in effect be self induced merely by a low energy photoflash. Furthermore, the fully transparent to radiation phototool in effect provided by this invention will have many applications not now evident.

This invention however does fully employ this phototool in an embodiment wherein a second photoexposure step may solely use that cured skin surface layer without the original phototool for the further curing of the layer throughout its thickness and the bonding of the layer to the substrate. This has the distinct advantage of dedicating a phototool on a production line only for an instant flash instead of for a full long cure cycle, and thus the production rate can be significantly improved.

In this second step, the photoexposure is achieved in air with an uncollimated low energy light source (because of the increased sensitivity of the liquid photopolymer) that does not cure the portions of the layer having a liquid state outer surface (which is inhibited by an air blanket on the surface), but which cures and bonds the patterned portion defined by the phototool in the first step as a surface stratum skin pattern. Thus, the photoflashed product of the first short flash exposure step may be removed from the phototool immediately and accumulated in a batch for "light tunnel" processing with a controlled amount of energy level and cure time, with very simple proceducral steps and equipment requirements.

Depending upon the characteristics of the liquid photopolymers being used, it may be desirable in the second step to use both the original phototool and the surrogate phototool together. Thus, a preferred photopolymer will have a large contrast in sensitivities of those portions of the layer with a cured skin and in the liquid state. If a large contrast ratio is not present in a particular polymer, or the available radiation intensity may tend to cure the regions with the unstable state surface, then the combination of the light blocking phototool and the transparent surrogate phototool will assure that the desired portions of the layer pattern are indeed fully cured and bonded without curing the portions to be washed out.

With the two phototools in tandem, the two separate forms of photo pattern discrimination provide advantages. The light blocking phototool pattern prevents any light energy from entering the photopolymer, keeping it cooler, and preventing reflections from the substrate. Thus the unwanted resolution decreasing components are principally stray rays inherent in a non-collimated source. The additional phototool discrimination of stray light rays through desensitized polymer thus further preserve the resolution integrity. Any marginal higher sensitivity under the skin pattern due to the nature of a particular liquid photopolymer characteristic that would make energy levels or cure times critical are overcome in this embodiment. This embodiment better tolerates pigmentation, etc. in photopolymers that might disturb the transparency to radiation and cause longer cure periods, or those without sufficient photoinitiators that also require longer curing periods.

Note that former photographically sensitive layers including photopolymers have been photo processed with a single uniform photo speed characteristic. Thus, the almost infinite exposure time for liquid photopolymer surfaces in air when radiation intensity is below the threshold level can be contrasted with very short exposure times of less than one minute when the skin stratum is polymerized to cap the liquid photopolymer surface as provided by this invention. Thus, in essence a very slow speed liquid photopolymer layer with a liquid phase surface exposed in air is changed into a high speed layer by means of a self priming short photo flash of about ten seconds with low energy in the presence of a protective gas blanket producing a polymerized outer skin on the liquid layer surface. Thereafter the same polymer layer when exposed in air is a high speed polymer requiring low energy photo radiation for polymerization.

## Brief Description of the Drawings

In the accompanying drawings

Fig 1 is a fragmental sketch in cross section of a printed wiring board with an unexposed thick layer of liquid photopolymer solder mask resist overlying wiring conductors and substrate surface portions of a printed wiring board,

Fig 2 is a system sketch in cross section of the photopolymer coated printed wiring board in position during a first off-contact photo-exposure step with uncollimated actinic radiation in the presence of a non-inhibiting gas for forming a skin deep polymerized surface pattern on the liquid phase surface of the polymer,

Fig 3 is a system sketch in cross section of the photopolymer coated printed wiring board in position during a second sequential photo-exposure step with uncollimated actinic radiation in the presence of air for curing the photopolymer layer through its thickness and bonding it to the printed wiring board substrate over a pattern defined by the phototool image,

Fig 4 is a system sketch in cross section of the photopolymer coated printed wiring board in position after a first sequential exposure step occurs in the presence of air on the surface, thereby leaving an uncured surface layer,

Fig 5 is a system diagram illustrating the curing process of another embodiment of this invention, wherein a two step photoexposure process requires an external light blocking phototool image only in the first radiating step, and

Fig 6 is a perspective sketch of a clamshell fixture used for practicing the invention, wherein gas may be admitted between a photo transparency and the polymer coated surface of a printed wiring board to blanket the surface, and thereafter removed and/or replaced, in accordance with the teachings of this invention.

## The Preferred Embodiments

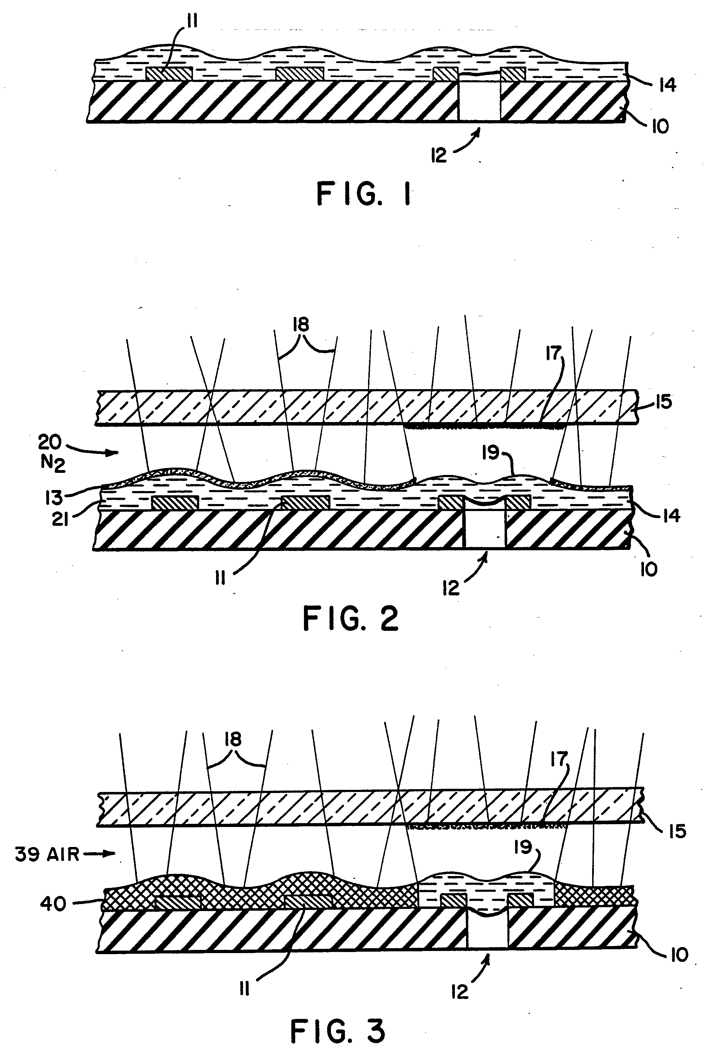

The following description refers to the accompanying drawings. In Fig 1, a printed wiring board substrate 10, having circuit wiring traces 11 thereon extending above the substrate surface, typically 0.010 cm, covered with a coating 14 of liquid photopolymer comprising for example a solder mask resist of a thickness, typically 0.013 cm, for covering the tops of the conductors with a solder resistant layer (when cured), typically of 0.003 cm thickness. Such printed wiring boards contain through holes 12, into which the liquid polymer layer may sag, ring the walls, or bridge. The thickness of such polymer layers therefore vary considerably across the substrate surface, with thickness variations typically five to one between the thickness over the substrate surface at a location adjacent to wiring traces and the top of the wiring traces respectively. This presents a significant problem in obtaining high resolution patterns of the solder mask. Thus, overexposure with resulting poor resolution tends to occur in the thin layer portions over the traces when enough photopatterning energy is provided to cure the thick layer portions over the substrate surface and furthermore to bond the photopolymer layer firmly to the substrate surface.

This problem is resolved by this invention by reducing the amount of energy required for cure, by curing in two separate curing steps and by providing polymers with special characteristics which permit photopatterning without overexposing in the two step process. The first step is illustrated in Fig 2, wherein a phototool comprising phototransparency 15 is spaced above and off-contact the liquid layer 14. An opaque radiation blocking image pattern 17 on the phototransparency 15 defines the desired photocopy pattern for distinguishing regions of the photopolymer layer 14 which are to be cured and which are to remain in the liquid state for removing in a solvent solution. The unstable liquid state portion 19 of the patterned layer shielded from the radiation in the first radiating step then has its surface in the liquid state. The portion to be polymerized throughout its thickness and bonded to the substrate and conductor surfaces however is cured through a surface stratum 13 only in this radiation step as a positive print of the phototool image where the light passes through.

The non-collimated radiation 18 is preferable as a low cost energy source and can be used herein because the process minimizes any loss of resolution generally caused by the stray rays from the uncollimated radiation. Typically the radiation source is a 5 kW UV light source, such as a mercury metal halide lamp with peak output at 360 and 400 nanometer wavelengths positioned a distance of about 1 meter from the photopolymer surface. When the gap 20 between the phototool 15 and the surface of the photopolymer has a non-reacting gas such as nitrogen or carbon dioxide therebetween, a ten second flash exposure, with an appropriate photopolymer composition, where light struck will polymerize the skin or capping portion 13 of the polymer layer extending downwardly partially through the layer thickness, such as to a depth of 0.003 cm to 0.008 cm. If this were a single step exposure of a duration of about 30 seconds or more so that the polymer layer 14 would be cured throughout its thickness and bonded to the surface of the substrate 10, overexposure would result significantly reducing resolution, particularly over the thinner layer areas overlying the circuit traces 11, in part because of the increased sensitivity of the polymer layer caused by the inert gas blanket that overcomes the oxygen inhibition characteristic of the photopolymer surface in the liquid state. Furthermore in the areas 19 of the photopolymer layer which are to remain in the liquid state, the increased sensitivity in the presence of the non-inhibiting gas could cause high radiation energy to polymerize undesirably these areas by means of stray radiation shadows and thus reduce resolution capabilities.

This outer barrier skin stratum 13, produced in this first short flash step presents a dry or gelled outer polymerized stable state surface that is not in the liquid polymer unstable state. Thus, a shield is presented over the remaining under portion of the layer 21 still in the liquid polymer state. This shield has the property of non-sensitivity to the presence of an inhibiting gas on its surface as has the unstable state photopolymer in the liquid state in regions 19. Thus this first exposure step converts the photopolymer layer of one photosensitivity (in the presence of air on the surface) to a layer having patterned areas of distinctly different photosensitivities, as will be hereinafter used in the second exposure step. This is a distinctly different process from the conventional manner of forming a dry film photopolymer by pre-exposing a liquid polymer, as for example described in US-A-4,291,118, since it does not result in a uniform polymerization or hardening throughout the surface. Nor do these prior art dry film pre-exposed layers result in a photopolymer layer that is not subject to photoinhibition by air or oxygen on the surface.

This first step therefore has produced a surrogate phototool which is an integral part of the polymer layer 14 and which is distinguished by a pattern (corresponding to that of phototool 15) through which actinic radiation is processed in a discriminatory way. Although the photopolymer layer is transparent to actinic radiation, and therefore permits it to pass through the entire thickness of the layer throughout both the liquid state surfaced regions 19 and the skin capped regions 21, the polymerizing effect of that radiation is drastically altered between the two regions.

The second photopatterning step in one embodiment of the invention is illustrated by way of Fig 3, wherein the nonreactive gas blanket (nitrogen) is replaced by an inhibiting gas 39 (air) that decreases the sensitivity of the polymer layer in those portions of the layer with a surface in the liquid polymer state. With the initial photopolymer layer 14 in the condition shown in Fig 2 comprising a surrogate phototool, the embodiment of Fig 3 thus has a tandem arrangement of two phototools with similar pattern designations in series between the actinic radiation source and the surface of the photopolymer layer 14. The conventional phototool transparency 15 has been formerly described as having a light blocking barrier image 17, whereas the light transparent portion of the photopolymer layer with its surface in the liquid state 19 serves as a light inactivating body that prevents the polymerization of the layer throughout its thickness in the presence of actinic radiation below a threshold level because of the inhibition action of the air blanket, or an equivalent inhibiting layer at the polymer surface. Conversely the capped skin layer 13 (Fig 2) will permit the entire layer thickness to be cured in the presence of actinic radiation of low energy levels by shielding the surface from the inhibiting gas.

With a second exposure time of thirty seconds, the thick 0.013 cm portions of the film become polymerized throughout their thickness and are bonded to the substrate 10 surface, as indicated by the hatching 40. The shadowed area 19 remains unpolymerized liquid throughout its thickness, and the resulting resolution is not deteriorated by overexposure or the presence of stray light rays from the uncollimated radiation 18 reaching the shadowed areas 19. The unpolymerized areas are washed out with a solvent in a conventional manner, and the polymerized regions 40 withstand the developer solvent, without loss of surface polymer therefrom.

Note that the in-situ surrogate phototool pattern thus provided in Fig 2 by means of skin layer 13 and corresponding liquid state surfaces 19 are not off contact and thus produce all the advantages of on-contact photoprinting without the corresponding prior art disadvantages hereinbefore set out. As a matter of fact this skin 13 phototool medium extends down into the photopolymer layer beneath its surface and thus gives even greater improvement than with contact printing with all its interfacing problems including the elimination of air bubbles.

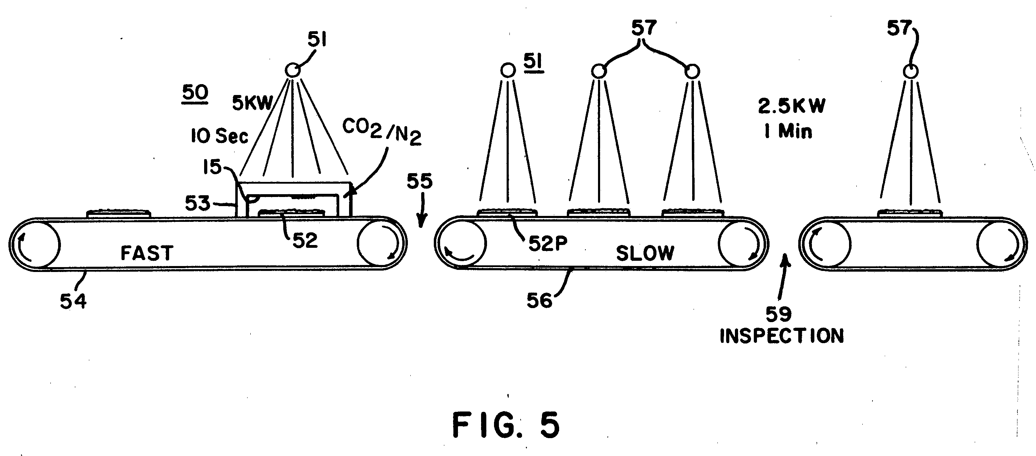

It is also to be recognized that this method is fast, energy efficient and non-critical in the placement and handling of the phototools. An even simpler and more basic production process is illustrated by the system of Fig 5, wherein the second step is achieved without patterned or blocked radiation patterns, simply by the use solely of the surrogate phototool provided in the first step for polymerizing the liquid polymer portion of the polymer layer underneath the barrier skin pattern 13 (Fig 2). Thus the leftmost region 50 represents the first photopatterning step, and region 50 toward the right represents the second photopatterning step.

In the first step öthe radiation source 51, typically a 5 kW UV lamp about 1 m above the surface of the photopolymer on a substrate 52 passing through compartment 53 having a non-reacting gas atmosphere (nitrogen or carbon dioxide) by means of a conveyor belt 54 for example, is radiated with a ten second exposure when within the protective atmosphere, as before described, causing the phototool 15 to produce the surrogate phototool pattern in the photopolymer layer on substrate 52. Note that the phototool here is only dedicated to the individual workpieces a very short time for photopolymer development (of the order of ten seconds), thereby making high volume production a reality.

The so processed and now photomasked substrates 52P are by some suitable transition means 55 transferred to a slowly moving conveyor belt 56 through the radiation field of the lower energy (2.5 kW) lamp 57 for a period such as one minute. This serves to polymerize the layer on the substrate 52P through its thickness under the skin (13) pattern without changing the liquid state of the layer pattern defined by the liquid surfaced polymer on the substrate. This exposure step is achieved in air in a conventional type light tunnel with low energy and without a dedicated external phototool or its registry requirement, etc.

The clam shell embodiment of Fig 6 provides a convenient fixture for the conservation of the protective gas layer (nitrogen or carbon dioxide) and if desired the alternation of such atmospheres with air, since one gas can be replaced by another in a rapid purging cycle. Thus a phototool transparency 60 having opaque portions 61 is hinged at 62 to a mounting surface 63 to open and close a gas containing compartment having gas entry and exit ports 69. The photopolymer covered substrate 58 is registered by pegs 66, or the like. Closure or latching structure 68 is provided and rollers 75 for moving the fixture past a radiation source.

The two photoexposure steps may also be reversed in order with particular advantage for some applications, as will become evident from the Fig 4 embodiment. Now the first exposure is made with an air blanket 39 in contact with the photopolymer layer surface, using a conventional off-contact phototool 15 with radiation blocking image patterns 17 thereon, and as before shown in the presence of un-collimated light. After a long exposure of thirty seconds or more to high energy radiation, the photopolymer layer is polymerized below its surface 43 and has a liquid state surface covering 44, as conventionally expected with air inhibited liquid photopolymer surfaces. The curing is firmly bonded to the substrate surface.

The second exposure step now follows through the transparency with a low energy flash after replacing the air blanket on the polymer surface with a non-reacting gas. The portion 19 remains in liquid polymer state throughout its layer thickness for washing out by solvent in a conventional development step.

Photopolymer characteristics are critical to the performance of this method. For example, a high ratio of oxygen inhibition of the wet surface compared with that uncured polymer under the cured skin barrier surface is a novel requirement imposed by this invention. The production of chemical resistance of the polymerized portions to washout solvents with low radiant energy is also desirable as well as the bonding characteristics to the substrate surface. The photopolymer in the liquid state should be of a pastelike viscosity to be deposited as a layer on the substrate by screen printing or the like with no residual air bubbles on either surface. This screen printing could be prepatterned, if desired, in the manner described in my US-A-4,610,841. The photosensitivity to radiation should conform with the criteria hereinbefore described. For solder masking properties there should be good adhesion to the substrate and copper wiring surfaces particularly in the presence of molten solder temperatures. The electrical resistance of layers as thin as 0.003 cm under all environmental conditions need be high to avoid circuit defects. Resolution need be good, in the order of more than 40 lines per cm, with the radiation sensitivity such to reject stray uncollimated radiation on the liquid state surfaces. A photopolymer composition providing this combination of features particularly suited for thick layers of pastelike consistency in the unstable liquid form that flows over circuit wiring without entrapping air bubbles, and which has enhanced properties of photosensitivity ratio of the nature provided by this invention, is now set forth in Example 1.

## EXAMPLE 1

| SOLDER MASK PHOTOPOLYMER COMPOSITION WITH ENCHANCED PHOTOSENSITIVITY RATIO | |
|---|---|
| Parts by weight | Ingredients |
| 80 | CELANESE CELRAD* 3600 UV/EP Resin |
| 20 | Trimethylopropane Triacrylate Diluent |
| 1 | CIBA-GEIGY IRGACURE* 500 Photoinitiator |
| 1 | MALLINKRODT Co. BYK-052 Defoamer |
| 0.0003 | Penn Color Co. PCN Green Pigment in Paste dispersion |

*Registered Trade Name

The foregoing two step photopatterning processes of Figs 1 through 3 were carried out in the manner described with the phototool displaced 0.05 cm off contact from the photopolymer surface. The development washout used butyl cellosolve as a solvent. After the two described steps a final cure was effected in a standard two 80 W per cm lamp UV reactor. The solder mask characteristics were tested with molten solder. The gas environment was conetrolled with a fixture as shown in Fig 6. The internal volume of gas was of the order of 100 cm$^2$, which was purged of air and replaced with nitrogen in fifteen seconds or less. In a preferred embodiment, carbon dioxide was found to be a non-reacting gas more readily available than nitrogen.

This photopolymer has the following characteristics with a 5 kW (reducible to 2.5 kW) mercury metal halide lamp with peak output at 360 and 400 nanometer wavelengths:

No residual air bubbles when applied to a substrate such as a printed wiring board in a layer by silk screening.

When a thick layer (0.010 cm) applied to a substrate is exposed for ten seconds at 1 meter distance with a nitrogen atmosphere, the polymerized depth is about 0.008 cm. When exposed to 2.5 kW for one minute it is polymerized through its thickness, but when exposed to 2.5 kW in air there is no significant polymerization throughout the thickness.

## EXAMPLE 2

### TENTING HOLES

One important requirement for solder masks is the ability to plug or tent selected holes in the board, as shown at 12 in Fig 1. It is necessary to be able to plug the holes with hardened photopolymer to prevent molten solder from being pumped through the hole from the underside, thereby forcing solder up and under electrical components to cause short circuits.

Holes of up to 0.08 cm in diameter were plugged by using the process of Examples 1 and 2, preceded by a coating step which forced liquid photopolymer into the holes, as depicted by photopolymer portion 14 bridging hole 12 (Fig 1). In order to plug the holes during the coating step a squeegee was crafted so as to deposit extra liquid photopolymer into holes while maintaining the controlled thickness on the surface of the board. The leading edge of the squeege, that is, the edge in contact with the screen fabric, was rounded, so as to deviate from the normal square edge. Holes so filled were subsequently permanently plugged by deleting the corresponding opaque areas 17 from phototransparency 15 so as to harden the photopolymer 14 in hole 12. When cured and soldered as previously described, the plugs were intact following a hot air leveling step.

## EXAMPLE 3

### MERGING FIRST AND SECOND PHOTOPATTERNING STEPS

The two distinct exposure steps of Examples 1 and 2 were combined into a single exposure step during which time the resident gas was replaced by a second gas. The resulting photopatterns were inferior to those produced by the two distinct exposure steps, since the gaseous state during the transition period was hard to predict, making it difficult to get the depth of cure required without overexposure. However there was a distinct advantage in the shorter cycle time.

EXAMPLE 4

### NON-COLLIMATED LIGHT SHADOW COMPENSATION

When the phototransparency 15 is off-contact by a distance in the order of 0.05 cm as shown in Fig 2 and when the light energy is non-collimated and comes from a point source, the resulting skin layer photopatterns 13 may be displaced or shifted from the position of the corresponding phototransparency images. This shift is caused by the light rays 18 radiating from the source in a radial, not parallel pattern. The shadow cast on the photopolymer surface by the opaque areas 17, will therefore be in dimensional agreement with the phototransparency only for points directly beneath the lamp centerline. At the extreme edge of the substrate the deviation of the light rays might reach the order of fourteen degrees and the images formed in the photopolymer will be displaced by the order of 0.013 cm. This shift is corrected by using a photoreduced phototransparency image so that when the shift occurs the resulting photopatterns will be correctly registered with the features of substrate 10 and metal conductors 11 on the printed wiring board. Thus a master phototransparency in dimensional agreement with the substrate is photoreduced by 0.07 percent in the Example 1 process to improve the registration.

EXAMPLE 5

### GAS SAVING SEQUENCE

When a gas chamber as in Fig 6 is used to change the gas environment for the two radiation steps, gas expenditure and processing time is decreased by processing two sequential substrates with the same gaseous environment thereby only requiring one gas change per substrate. This is possible because the two radiating steps are reversible in order as long as an external phototool is used in both steps.

EXAMPLE 6

### BOARD SALVAGE

Salvaging reject printed wiring boards in the production process is readily done in this invention by controlling the amount of radiating energy before final bonding, as may be seen from the Fig 5 inspection station 59. Before a post inspection cure step more thoroughly bonding the polymer to the substrate is applied either in the process steps or as a separate bonding step at a later time, the polymer may be radiated just enough to bond the layer to the substrate so that it may be stripped without damage to an expensive circuit board thereunder.

EXAMPLE 7

## DRY FILM EMBODIMENT

The liquid photopolymer of the former example was replaced by a dry film layer available form Dupont as "Product 730 S" consisting of a 0.008 cm thick photopolymer layer covered by a clear polyester sheet. This polymer was laminated onto the printed wiring substrate with the outer polyester sheet in place to protect the polymer from oxygen. A phototransparency with an opaque image thereon was placed in contact with the clear polyester sheet for a flash exposure for eight seconds from the 5 kW source at 1.5 m. In the second step, the polyester sheet was peeled from the photopolymer surface to expose it to air, and the exposure followed with unpatterned radiation from the 2.5 kW source at 1.5 m for four minutes. The unstable state polymer was removed in a trichlorethane solvent to leave a fully stable state pattern. The final curing step prepared the product for acceptable solder mask properties in the presence of molten solder. This process was more critical than that with the liquid photopolymer of Example 1 because the differential photosensitivity in the presence of oxygen was not nearly as great as for the liquid photopolymer specially formulated for operation in this mode.

## EXAMPLE 8

### PLASTIC FILM COVERED LIQUID PHOTOPOLYMER EMBODIMENT

The process of Example 1 was repeated with a clear plastic film laminated over the liquid photopolymer as a means of excluding air from its surface rather than the non-reacting gas. After the first exposure the plastic film was peeled from the surface and the second exposure followed with comparable results.

## Claims

1. The method of photographically producing selected patterns in a photosensitive material convertible by actinic radiation from a first unstable state that is subject to chemical and physical distortion into a second stable state more resistant to chemical and physical distortion, **characterized** by radiating a body of said material in the unstable state with a controlled pattern and quantity of actinic radiation to produce variations in the photosensitivity of the material for converting to the stable state in response to further radiation unstable state material in two respective regions identified by said controlled pattern.

2. The method of claim 1, **characterized** by a layer of photopolymer material with the characteristic of responding to the presence of an inhibiting gas on its surface in the unstable state by requiring an increase in the amount of radiation necessary to convert the material into its stable state, wherein the radiating step is administered while protecting the surface of the photopolymer from inhibiting gas thereby to convert to the stable state in said pattern an outer skin surface stratum to constitute a region which shields an underlying stratum of material in the unstable state from inhibiting gas thereby requiring less radiation intensity to cure the layer through the thickness thereof under the outer skin stratum than that intensity of radiation required to convert the layer having an unstable state outer surface into the stable state.

3. The method of claim 1, **characterized** by the body of material being disposed in a layer with the two unstable state regions respectively comprising one region in the unstable state through the thickness of the layer and another region in the unstable state underneath an outer surface stratum of the material in the stable state, and the step of:

further radiating the body with actinic radiation of an intensity reacting substantially with only that region of the body in the unstable state under the stable state skin stratum thereby to convert a corresponding pattern of that region into the stable state throughout the thickness of the layer.

4. The method defined in claim 3, **characterized** in that the material is a liquid photopolymer having an unpolymerized unstable liquid state and a polymerized stable state.

5. The method of claim 3, **characterized** in that the initial radiation is patterned through a phototool with an imaged pattern thereon of radiation opaque material, and the further radiating step is unpatterned.

6. The method defined in claim 3, **characterized** in that the initial radiation is patterned through a phototool with an imaged pattern thereon of radiation opaque material, and the further radiating step follows through a tandem of phototools comprising the first said phototool and a surrogate phototool comprising said outer surface stratum.

7. The method defined in claim 6, **characterized** in that the material is a photopolymer having the characteristic of having reduced sensitivity to radiation for curing in the presence of air on the surface, with the step of protecting the surface of the layer with a non-inhibiting gas in the first radiation step to produce said surface stratum.

8. The method defined in claim 2, **characterized** in that the two different regions reacting with different sensitivities are patterned by surface patterns on the body respectively in the stable and unstable states, comprising the further step of disposing on the surface of the body in a second radiating step an inhibiting gas medium that substantially reduces the sensitivity to radiation of those regions presenting surface portions in the stable state.

9. The method of claim 2, **characterized** in that the radiation step constitutes a short flash of radiation energy passed through a phototool with an opaque image pattern thereon with controlled energy for curing a pattern on the outer surface of the layer partly through its thickness.

10. The method of claim 9, **characterized** by a second radiation step in the presence of air following said short flash with the second radiation being passed through a tandem array of two phototools comprising a first phototool transparency and a surrogate phototool comprising said outer skin surface stratum.

11. The method of claim 2, **characterized** by the step of further radiating the layer with unpatterned radiation, whereby the patterned surface stratum of the stable state material consists of a radiation transparent in-situ phototool pattern in the further radiating step.

12. The method of claim 1 wherein the photosensitive material is a layer of photopolymer having the characteristic of its photosensitivity being inhibited in the presence of air on the surface, **characterized** by the steps of increasing the sensitivity by means of changing a gaseous atmosphere on the surface of the material from air to a non-inhibiting gas during the first of two successive photographic exposure steps, and limiting the radiation energy in the first exposure step to produce a cured outer surface stratum protecting an underlying uncured stratum from the presence of air in the second exposure step.

13. The method of claim 1, **characterized** by a photosensitive material having its photosensitivity inhibited in the presence of air on the surface of the material with a first said exposure step in the presence of a gaseous atmosphere that does not inhibit the photosensitivity of the material and the second step in the presence of air, and comprising the step of exposing the material to unpatterned radiation in the presence of the air, thereby to produce a cured pattern only in a pattern below the surface stratum by means of different photosensitivity patterns in the material.

14. The method of claim 1, **characterized** by a thin layer of the material with the property of changing photosensitivity with stratum layer on its outer surface in the suble state, comprising the step of limiting the amount of exposure energy in one of two successive exposure steps to produce a cure partly through the thickness of the layer from the outer surface in a predetermined exposure pattern, thereby to provide a material having two different photo sensitivities for presentation to the second exposure step.

15. The method of claim 1, **characterized** by the steps of further radiating said body of material with metered radiation energy in said controlled pattern to convert a surface stratum to the stable state with unstable state material thereunder with the material over a region in a further pattern remaining in the unstable state throughout its thickness, thereby to vary the photosensitivity of the material over the respective said patterns for the further radiation.

16. The method of claim 1, **characterized** by a material having differing photosensitivity in the presence of different gaseous atmospheres on its surface, comprising the steps of producing a gaseous atmosphere in a chamber for confining an atmosphere of different gases providing different photosensitivities and replacing one gas atmosphere with another in a rapid purging cycle with the material in place in said chamber, and providing said radiation and further radiation in the presence of different gases.

17. The method of claim 16, **characterized** by the steps of inserting a printed wiring board having a liquid photopolymer layer thereon to be cured in a pattern into the chamber, retaining the board therein for said two different said gas atmospheres, one comprising a gas constituency that inhibits the curing of the layer and the other an uninhibiting gas constituency, and photoexposing the layer in the presence of the different gases with a metered amount of radiation energy disposed through an intervening phototransparency to produce said pattern in the layer of an outer surface stratum of cured polymer.

13

18. The method of claim 16, **characterized** by the step of providing overlapping photoexposure by radiation through a phototool pattern in the presence of a change in constituency of the gas to obtain the two different gas atmospheres.

19. The method of claim 16, **characterized** by the step of providing two separate patterned photoexposure steps in the presence of the two different gas atmospheres.

20. The method of claim 1, **characterized** in that the body is a layer of photopolymer photoactive material with the characteristio that when the surface thereof in the unstable state is subjected to an inhibiting gas, much greater radiation energy is required to convert it into the stable state, and the steps of protecting the surface of the photopolymer layer from the inhibiting gas while producing said stratum pattern in one region as an outer surface in the stable state with a further region of the polymer in the unstable state throughout its thickness thereby to create a surface layer protecting the material from the inhibiting gas during said further radiation.

21. The method of claim 1, **characterized** in that the body of material is a layer of liquid photopolymer disposed by screen coating upon a substrate having through holes therein, and the steps of depositing extra liquid photopolymer into the holes while maintaining a controlled thickness of the layer by means of a squeegee having a rounded edge in contact with the screen disposing the coating, and converting the liquid photopolymer in selected holes to the stable state by radiation energy.

22. The method of claim 1, **characterized** in that the radiation is uncollimated energy coming from a lamp source displaced from the body by a predetermined distance which directs rays radially toward the body, the controlled pattern is formed by the radiation through a phototool image disposed off-contact from the body for imaging on the body an imaged radiation pattern of predetermined dimensions, and the image on the phototool is dimensionally smaller than said predetermined dimensions by an amount compensating for the radial pattern of the rays.

23. The method of claim 1, **characterized** by a body of material having a photosensitivity related to the presence of a gas atmosphere on the surface of the material comprising the step of further radiating the body of material with an energy intensity and quantity that will convert the unstable state material in only one of the two regions into the stable state by respectively adminstering the radiation in the presence of two different gaseous atmospheres on the surface of the body.

24. The method of claim 23, **characterized** in that the body is disposed as a layer upon a substrate, successive substrates are processed in a chamber establishing the gaseous atmospheres, and the gas is changed in the chamber after processing two successive substrates with the same gas.

25. The method of claim 1, **characterized** in that the material body is a layer of solder mask material disposed upon a printed wiring board and including the steps of further radiating the layer to convert a pattern therein to the stable state and to bond to the printed wiring board the stable state material by radiation limited in energy to form a bond to the board that permits removal without damaging the board in a salvage operation.

26. The method of claim 1, **characterized** in that the controlled pattern of radiation is produced by passing radiation through a phototool image which blocks radiation with an opaque image, the radiation step comprises a short flash of radiation energy through the phototool to create two regions of differing photosensitivity, and a further radiation step is limited in magnitude to discriminate between the regions of differing photo sensitivity to produce a pattern in one said region in the stable state without the phototool, thereby releasing the phototool for a further similar step with a successive body before the pattern is fully converted to the stable state to reduce the percentage of curing time the phototool need be dedicated to the production of the pattern of stable state material.

27. An in situ radiation transparent phototool for actinically exposing a pattern in a layer of photoactive material disposed on a substrate, which material changes its physical properties from an unstable to a stable state in response to furhter actinic radiation, **characterized** by a surface stratum of material in the stable state over a patterned region of the surface extending through an outer portion of the thickness of the layer thereby forming an image pattern over an underlying unstable state portion of the layer with the remainder of the surface comprising a region with the layer through the thickness thereof remaining in the unstable state.

28. The phototool of claim 28, **characterized** by an unstable state photopolymer material having the characteristic of inhibition to conversion to the stable state throughout the layer thickness in the presence of actinic radiation when the unstable state surface is in the presence of an inhibiting gas thereby to require greater actinic radiation energy to change the material from the unstable state to the stable state.

29. The phototool of claim 27, **characterized** in that the photoactive material comprises a liquid photopolymer layer of a maximum thickness in the range of about 0.005 to 0.010 cm.

14

30. The phototool of claim 27, **characterized** in that the photoactive material comprises a dry film layer of photopolymer having the characteristic of inhibition of polymerization by actinic radiation when the surface is in the presence of air thereby to require greater radiation energy to polymerize the layer than when the surface is covered by a means keeping air from the surface.

31. The phototool of claim 27, **characterized** in that the photoactive material is a photopolymer having the characteristic that an inhibiting gas on a surface in an unstable state requires a high threshold level of radiation energy to convert the state to a stable state, and having a contrasting characteristic that a low threshold level of radiation energy converts the unstable state to a stable state when the unstable state surface is shielded from the inhibiting gas.

32. A photoactive photopolymer material having an unstable state transformable by actinic radiation to a stable state with the enhanced characteristic that in the presence of an inhibiting gas on a surface thereof a high threshold level of actinic energy is required to produce the stable state and with a contrasting characteristic that a low threshold of radiation converts the unstable state to a stable state when the surface is shielded from the inhibiting gas such that a radiation transparent patterned layer positioned adjacent a portion of the surface of an unstable state layer of the material will permit a corresponding patterned layer of the material thereunder to be transformed into the stable state by radiation energy between said threshold levels without converting the rest of the unstable state layer into the stable state.

FIG. 1

FIG. 2

FIG. 3

**39 AIR →**

44
40

17      19

43

11

12

10

15

# FIG. 4

For the purpose of publication, only
correction(s)
☐ allowed
☐ allowed with exception
    of the deleted points
☐ not allowed
Signature:                date: 29/4/80
                          Receiving Section

61

62      69                              75

63                                      68

60

69

65

75                                      
         67                             65

66

# FIG. 6

FIG. 5